# EUROPEAN PATENT APPLICATION

(11) **EP 2 765 217 A1**
(43) Date of publication of application: **13.08.2014**
(21) Application number: 14153996.5
(22) Date of filing: 05.02.2014
(51) Int. Cl.: C23C 16/452, H05H 1/24, H01J 37/32

(54) **Remote plasma generation apparatus**

(30) Priority: 08.02.2013 KR 20130014704; 26.06.2013 KR 20130073901
(71) Applicant: Korea Institute Of Machinery & Materials, Yuseong-gu Daejeon 305-343 (KR)
(72) Inventor: Kang, Woo Seok, Daejeon 305-343 (KR); Hur, Min, Daejeon 305-343 (KR); Lee, Jae Ok, Daejeon 305-343 (KR); Song, Young Hoon, Daejeon 305-343 (KR); Kim, Kwan-Tae, Daejeon 305-343 (KR); Lee, Dae-Hoon, Daejeon 305-343 (KR)
(74) Representative: Delorme, Nicolas

(57) **Abstract**

A remote plasma generation apparatus (100) that can enhance plasma processing efficiency by centralizing remote plasma to a processing object (40) is provided. The remote plasma generation apparatus (100) includes: a dielectric support body (10) that has a main body (15) that is connected to a discharge gas injection opening (11) and a nozzle portion (16) that is connected to a plasma outlet (12); a driving electrode (20) that is fixed to the main body (15) and that receives application of an AC voltage from a power supply unit (21) to generate plasma at internal space of the main body; and a ground electrode (30) that supports a processing object (40) at the outside of the nozzle portion (16). The nozzle portion includes an inclined surface (161) that is integrally connected to the main body (15), and by forming a width of the plasma outlet (12) to be smaller than a width of the main body, remote plasma is concentrated to the processing object (40).

## Description

### CROSS-REFERENCE TO RELATED APPLICATION

This application claims priority to and the benefit of Korean Patent Application No. 10-2013-0014704 and 10-2013-0073901 filed in the Korean Intellectual Property Office on February 8, 2013 and June 26, 2013, the entire contents of which are incorporated herein by reference.

### BACKGROUND OF THE INVENTION

### (a) Field of the Invention

The present invention relates to a remote plasma generation apparatus. More particularly, the present invention relates to a capacitively coupled (or capacitive coupling) plasma generation apparatus.

### (b) Description of the Related Art

An existing plasma generation apparatus uses a method of generating plasma within a narrow gap in a low pressure condition, and positioning and directly processing a processing object within plasma. In this case, in order to enhance process efficiency, when increasing power consumption, energy and density of plasma are enhanced, but a processing object is damaged by high energy electrons or ions. Further, due to a limitation of a structure that generates plasma at a narrow gap, large capacity or large area processing is difficult.

In order to compensate for such a problem, remote plasma processing technology that processes plasma that is generated in a plasma reactor by moving to a long distance has been suggested. However, an existing remote plasma generation apparatus uses microwave or inductively coupled plasma (ICP) using a high frequency (RF) power source, requires matching technology between a plasma reactor and a power source, and is weak in a load change, and it is difficult to drive the existing remote plasma generation apparatus in a high pressure. Particularly, due to a limitation of ICP power supply technology, a limitation exists in power increase, large capacity, and large area processing.

The above information disclosed in this Background section is only for enhancement of understanding of the background of the invention and therefore it may contain information that does not form the prior art that is already known in this country to a person of ordinary skill in the art.

### SUMMARY OF THE INVENTION

The present invention has been made in an effort to provide a capacitively coupled remote plasma generation apparatus having advantages of generating spatially uniform plasma in a wide pressure condition and easily performing large capacity and large area processing, and enhancing plasma processing efficiency by centralizing remote plasma to a processing object.

An exemplary embodiment of the present invention provides a remote plasma generation apparatus including: a dielectric support body that has a main body that is connected to a discharge gas injection opening and a nozzle portion that is connected to a plasma outlet; a driving electrode that is fixed to the main body and that receives an AC voltage from a power supply unit to generate plasma at an internal space of the main body; and a ground electrode that supports a processing object at the outside of the nozzle portion. The nozzle portion includes an inclined surface that is integrally connected to the main body, and by forming a width of the plasma outlet to be smaller than a width of the main body, remote plasma is concentrated to the processing object.

The main body may include a pair of long side portions that are opposite to each other in a first direction and a pair of short side portions that are opposite to each other in a second direction.

The inclined surface may include a pair of inclined surfaces that are opposite to each other in one direction of the first direction and the second direction. The inclined surface may include a pair of first inclined surfaces that are opposite to each other in the first direction and a pair of second inclined surfaces that are opposite to each other in the second direction.

The main body may be formed in a cylindrical shape, and the nozzle portion may be formed in a funnel shape and thus the plasma outlet may have a smaller diameter than that of the main body.

The remote plasma generation apparatus may further include a plurality of transfer rollers that are positioned at both sides of the ground electrode, wherein the plurality of transfer rollers may move a processing object in one direction in a remote plasma processing process.

The ground electrode may include a first ground electrode that supports the processing object and a second ground electrode that is fixed to the dielectric support body. The second ground electrode may contact an outer wall of the main body, and may be positioned between the driving electrode and the nozzle portion.

The remote plasma generation apparatus may further include a chamber that encloses the nozzle portion and that is fixed to the main body. The chamber may be connected to a ground potential.

According to a remote plasma generation apparatus of the present exemplary embodiment, as a dielectric support body has a nozzle portion, an electric field of a plasma injection area can be concentrated and a flow velocity can be quickened. Therefore, the remote plasma generation apparatus can centralize remote plasma to a processing object and a remote plasma processing effect can be enhanced.

### BRIEF DESCRIPTION OF THE DRAWINGS

FIG. 1 is a perspective view illustrating a remote plasma generation apparatus according to a first exemplary embodiment of the present invention.
FIG. 2 is a cross-sectional view illustrating the remote plasma generation apparatus of FIG. 1.
FIG. 3 is a perspective view illustrating a first exemplary variation of the remote plasma generation apparatus of FIG. 1.
FIG. 4 is a cross-sectional view illustrating a second exemplary variation of the remote plasma generation apparatus of FIG. 1.
FIG. 5 is a perspective view illustrating a remote plasma generation apparatus according to a second exemplary embodiment of the present invention.
FIG. 6 is a side view illustrating a remote plasma generation apparatus according to a third exemplary embodiment of the present invention.
FIG. 7 is a perspective view illustrating a third exemplary variation of the remote plasma generation apparatus of FIG. 1.
FIG. 8 is a cross-sectional view illustrating a remote plasma generation apparatus according to a fourth exemplary embodiment of the present invention.
FIG. 9 is a cross-sectional view illustrating a remote plasma generation apparatus according to a fifth exemplary embodiment of the present invention.

### DETAILED DESCRIPTION OF THE EMBODIMENTS

The present invention will be described more fully hereinafter with reference to the accompanying drawings, in which exemplary embodiments of the invention are shown. As those skilled in the art would realize, the described embodiments may be modified in various different ways, all without departing from the spirit or scope of the present invention.

In the specification, unless explicitly described to the contrary, the word "comprise" and variations such as "comprises" or "comprising" will be understood to imply the inclusion of stated elements but not the exclusion of any other elements. Further, in the specification, when it is said that any part, such as a layer, film, region, or plate, is positioned on another part, it means the part is directly on the other part or above the other part with at least one intermediate part. Further, in the specification, an upper part of a target portion indicates an upper part or a lower part of the target portion, and it does not mean that the target portion is always positioned at the upper side based on a gravity direction.

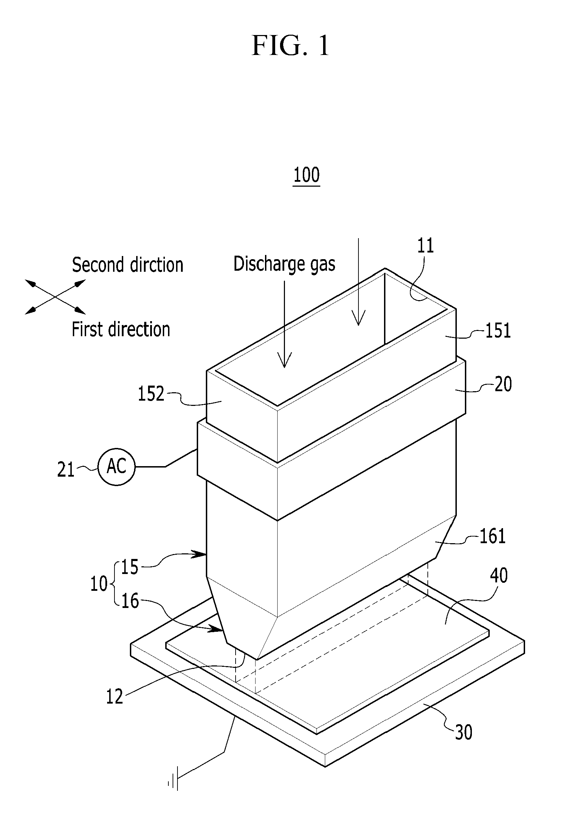

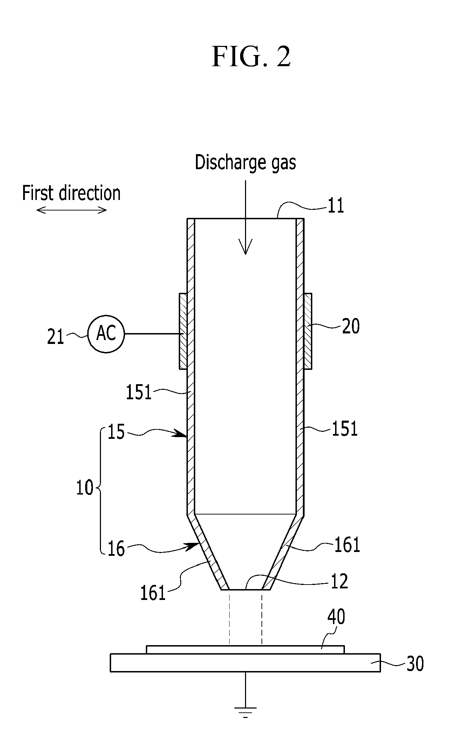

FIG. 1 is a perspective view illustrating a remote plasma generation apparatus according to a first exemplary embodiment of the present invention, and FIG. 2 is a cross-sectional view illustrating the remote plasma generation apparatus of FIG. 1.

Referring to FIGS. 1 and 2, a remote plasma generation apparatus 100 of the first exemplary embodiment includes a dielectric support body 10, a driving electrode 20 that is fixed to the dielectric support body 10, and a ground electrode 30 that supports a processing object 40 at the outside of the dielectric support body 10. In this case, the dielectric support body 10 is formed in a structure that concentrates an electric field of a plasma injection area and that centralizes remote plasma to the processing object 40 by quickening a flow velocity.

The dielectric support body 10 is a pipe or duct-shaped member that is produced with a dielectric material and forms a plasma generation space therein. The dielectric support body 10 forms a discharge gas injection opening 11 at one side and forms a plasma outlet 12 at one side of the opposite side thereof. The dielectric support body 10 may have various sectional shapes such as a quadrangle and a circle according to a shape of the processing object 40. FIG. 1 illustrates the dielectric support body 10 having a quadrangular sectional shape.

The discharge gas injection opening 11 of the dielectric support body 10 is connected to a gas supply apparatus and a flow regulator that are not shown. A discharge gas that is injected to the inside of the dielectric support body 10 may be an inert gas such as helium (He), neon (Ne), Argon (Ar), and nitrogen (N₂), or a mixture of an inert gas and clean dry air.

Further, a reactive gas or a process gas may be added to a discharge gas, as needed. The reactive gas or the process gas can be variously selected according to usage (cleaning, etching, atomic layer deposition, surface treatment, and material decomposition) of the remote plasma generation apparatus 100. The reactive gas or the process gas may include SF₆, CH₄, CF₄, O₂, or NF₃, and a liquid precursor such as tetraethyl orthosilicate (TEOS), tetrakis(ethylmethylamino)zirconium, trimethyl aluminum (TMA), and hexamethyldisiloxane (HMDSO).

The driving electrode 20 contacts an outer wall of the dielectric support body 10, and may be disposed to enclose the dielectric support body 10 in a width direction. The driving electrode 20 is electrically connected to a power supply unit 21, and receives application of an AC voltage necessary for generating plasma. An AC voltage that is applied to the driving electrode 20 may have a magnitude of several hundred volts or more, and frequency characteristics of several tens of kilohertz to several tens of megahertz bands.

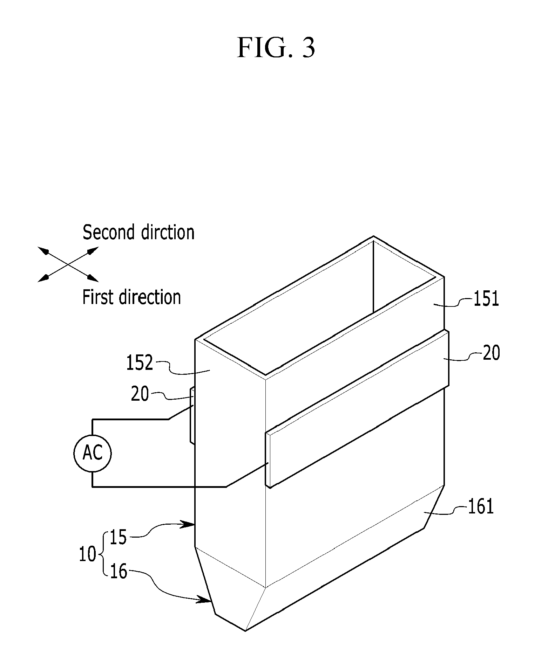

The driving electrode 20 may be fixed to a portion of an outer wall of the dielectric support body 10. That is, the driving electrode 20 may be disposed to completely enclose a portion of the dielectric support body 10, as shown in FIG. 1, or may be divided and disposed at two opposite surfaces of four surfaces (a pair of long side portions or a pair of short side portions) of the dielectric support body 10, as shown in FIG. 3. When the dielectric support body 10 has a rectangular sectional shape, the driving electrode 20 may be divided and fixed to a pair of long side portions having a large width.

The ground electrode 30 is positioned at a predetermined distance from the plasma outlet 12 at the outside of the dielectric support body 10 and supports the processing object 40. The processing object 40 is positioned under the plasma outlet 12, and receives remote plasma that is discharged from the dielectric support body 10 to perform plasma processing.

When applying an AC voltage to the driving electrode 20 while injecting a discharge gas to the dielectric support body 10, an electric field is formed at the inside of the dielectric support body 10 by a potential difference between the driving electrode 20 and the ground electrode 30, and thus plasma discharge occurs.

Plasma discharge occurs when a driving voltage of an internal gas is higher than a breakdown voltage thereof, and while a discharge current continuously increases, as a stacking amount of wall charges increases at a surface of the dielectric support body 10, plasma discharge decreases. That is, after discharge starts, as the discharge current increases, space charges within plasma are stacked on the dielectric support body 10 and thus wall charges are generated.

Wall charges perform a function of suppressing a voltage that is applied from the outside, and discharge is sequentially weakened by a wall voltage of such a dielectric support body 10. While an applied voltage is maintained, plasma discharge repeats generation, maintenance, and extinction processes. Therefore, while discharge is not changed to an arc, a large capacity of plasma may be effectively generated with a lower voltage.

Plasma that is generated at the inside of the dielectric support body 10 is ejected to a processing object in a form of remote plasma through the plasma outlet 12. That is, remote plasma is plasma that is diffused from a plasma generation source.

Process related factors that are generated in plasma include electrons, an ions, neutral particles/radicals, and ultraviolet rays. When electrons and ions are adjacent to a plasma generation source, the electrons and ions have high intensity, and neutral particles/radicals more richly exist in remote plasma. The remote plasma generation apparatus 100 is appropriate for plasma processing that actively uses neutral particles/radicals than electrons and ions.

In the remote plasma generation apparatus 100 of the present exemplary embodiment, the dielectric support body 10 includes a main body 15 that encloses the plasma generation space, and a nozzle portion 16 that is connected to the main body 15 and that forms the plasma outlet 12 having a width smaller than that of the main body 15. The nozzle portion 16 performs a function of enhancing plasma processing efficiency by centralizing remote plasma to the processing object 40.

The nozzle portion 16 includes a pair of inclined surfaces 161 that are opposite to each other in one direction. In the dielectric support body 10, a pair of long side portions 151 constituting the main body 15 are opposite to each other in a first direction, and a pair of short side portions 152 are opposite to each other in a second direction, and one direction in which a pair of inclined surfaces 161 are opposite may be one direction of the first direction and the second direction.

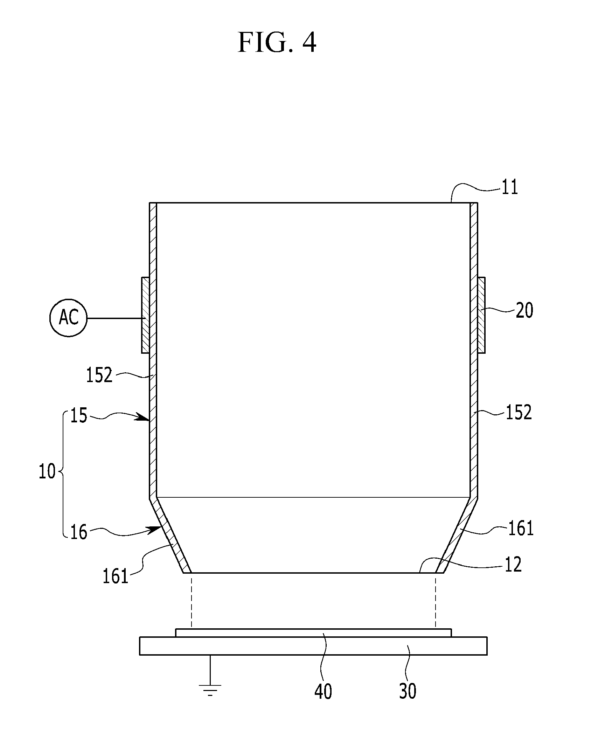

FIGS. 1 and 2 illustrate a case in which a pair of inclined surfaces 161 constituting the nozzle portion 16 are opposite in the first direction. In this case, a width of the plasma outlet 12 according to the first direction is smaller than that of the main body 15 according to the first direction. FIG. 4 illustrates a case in which a pair of inclined surfaces 161 constituting the nozzle portion 16 are opposite in the second direction. In this case, a width of the plasma outlet 12 according to the second direction is smaller than that of the main body 15 according to the second direction.

Remote plasma is affected by an electric field and a fluid field, and as the dielectric support body 10 has the nozzle portion 16, an electric field of a plasma injection area is concentrated and flow velocity is quickened. Therefore, the remote plasma generation apparatus 100 of the present exemplary embodiment can centralize remote plasma to the processing object 40, and a remote plasma processing effect can be enhanced.

The remote plasma generation apparatus 100 of the present exemplary embodiment can be effectively applied to a surface treatment process of a polymer substrate of a flexible display device and an atomic layer deposition (ALD) process.

The foregoing remote plasma generation apparatus 100 uses a capacitively coupled method, does not require special matching technology, and can easily perform large capacity and large area plasma processing according to a size of the dielectric support body 10. Further, the foregoing remote plasma generation apparatus 100 has a wide driving range of several mTorr to several Torr, and can easily control a process variable by adjusting a change level of an electric field and a flow velocity according to an inclined angle of the inclined surface 161 constituting the nozzle portion 16.

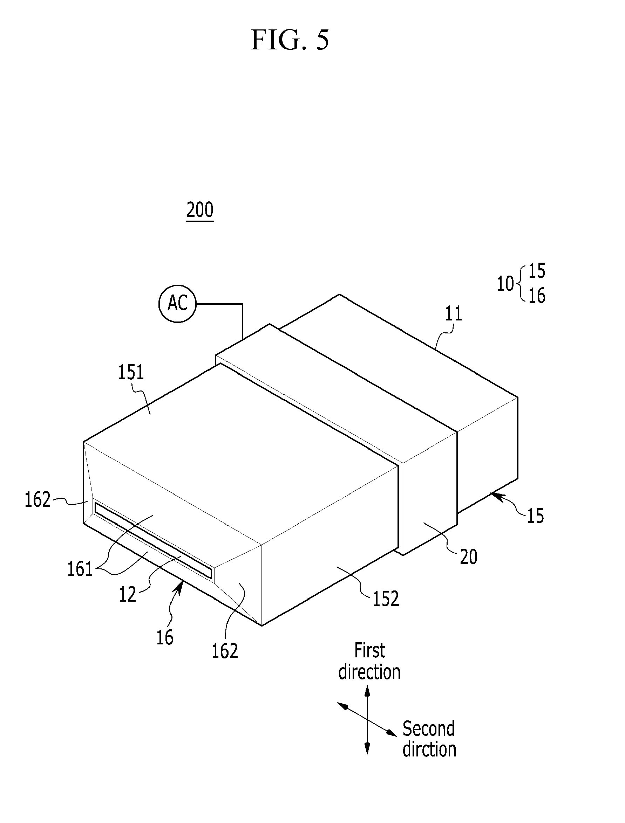

FIG. 5 is a perspective view illustrating a remote plasma generation apparatus according to a second exemplary embodiment of the present invention, and illustrates a state in which a nozzle portion is disposed to face the front side of the drawing.

Referring to FIG. 5, a remote plasma generation apparatus 200 of the second exemplary embodiment has a configuration of the foregoing first exemplary embodiment, except that the nozzle portion 16 are formed with four inclined surfaces 161 and 162. In the second exemplary embodiment, constituent elements identical to or corresponding to those of the first exemplary embodiment are denoted by the same reference numerals.

In a dielectric support body 10, a pair of long side portions 151 are opposite to each other in a first direction, and a pair of short side portions 152 are opposite to each other in a second direction. The nozzle portion 16 is formed with a pair of first inclined surfaces 161 that are opposite to each other in the first direction and a pair of second inclined surfaces 162 that are opposite to each other in the second direction. Therefore, a width of a plasma outlet 12 according to the first direction and the second direction is smaller than that of the main body 15 according to the first direction and the second direction.

In the second exemplary embodiment, as the nozzle portion 16 reduces a width of the plasma outlet 12 at both of the first direction and the second direction, the nozzle portion 16 concentrates an electric field in both the first direction and the second direction and quickens the flow velocity, remote plasma can be concentrated with a higher density toward a processing object.

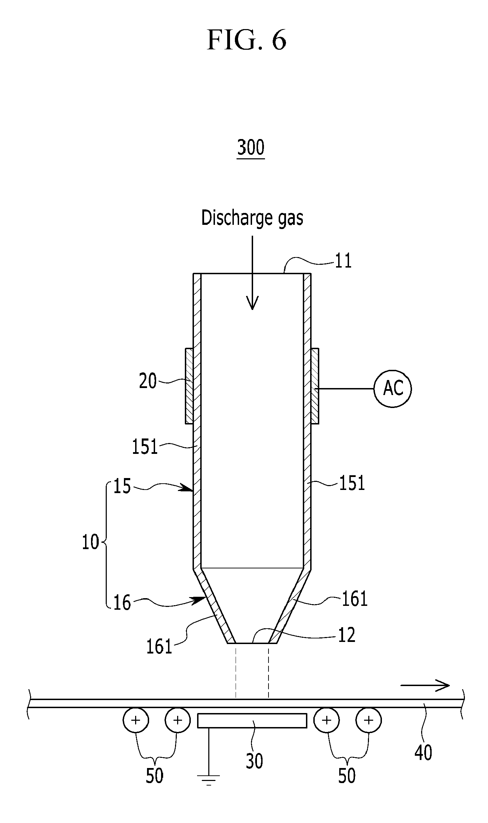

FIG. 6 is a side view illustrating a remote plasma generation apparatus according to a third exemplary embodiment of the present invention.

Referring to FIG. 6, a remote plasma generation apparatus 300 of the third exemplary embodiment has the same configuration as that of the foregoing first exemplary embodiment or second exemplary embodiment, except that a plurality of transfer rollers 50 for moving a processing object 40 are installed. FIG. 6 illustrates a basic configuration of the first exemplary embodiment, and in the third exemplary embodiment, constituent elements identical to or corresponding to those of the first exemplary embodiment are denoted by the same reference numerals.

A plurality of transfer rollers 50 are divided and positioned at both sides of a ground electrode 30 and move the processing object 40 in one direction. Therefore, when the processing object 40 is positioned under a plasma outlet 12 while being transferred by the plurality of transfer rollers 50, the processing object 40 receives remote plasma to perform plasma processing.

The processing object 40 may be formed in a film form in which roll-to-roll transfer is possible, and the remote plasma generation apparatus 300 of the third exemplary embodiment can continuously perform plasma processing of the processing object 40.

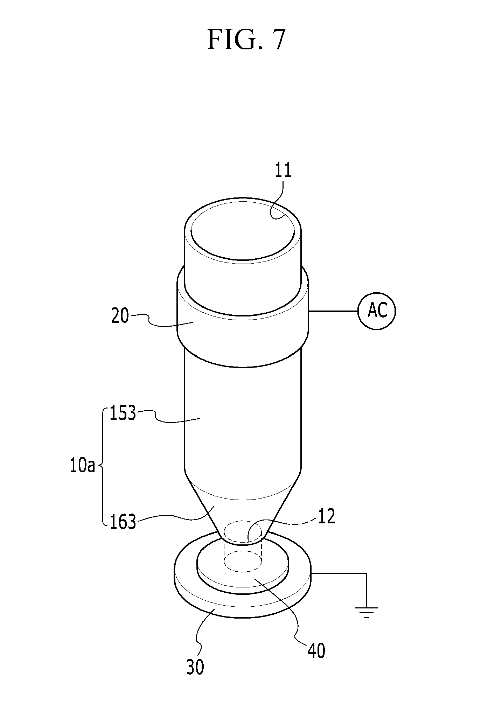

FIGS. 1 to 6 exemplify the dielectric support body 10 of a rectangular duct shape, but as shown in FIG. 7, a dielectric support body 10a may be formed in a cylindrical shape.

FIG. 7 is a perspective view illustrating a third exemplary variation of the remote plasma generation apparatus of FIG. 1. Referring to FIG. 7, a main body 153 of the dielectric support body 10a is formed in a cylindrical shape, and a nozzle portion 163 is formed in a funnel shape. A plasma outlet 12 is formed in a circular shape and is formed with a diameter smaller than that of the main body 153. In this case, a driving electrode 20 may be disposed to enclose the main body 153 in a cylinder direction of the main body 153. The remote plasma generation apparatus that is shown in FIG. 7 is appropriate for plasma processing of a semiconductor wafer.

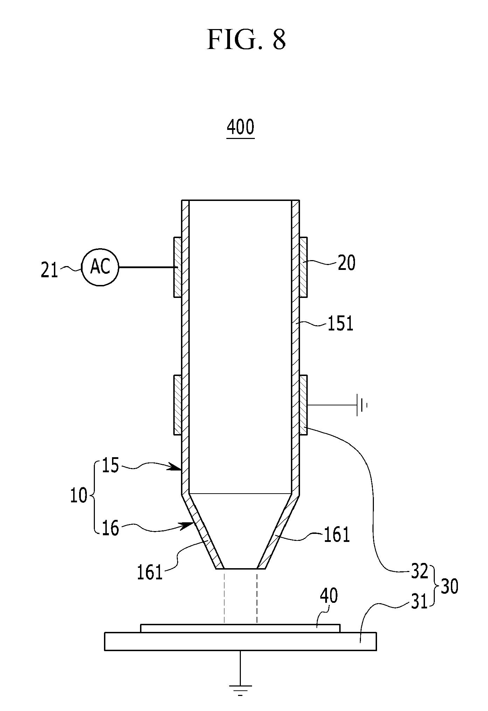

FIG. 8 is a cross-sectional view illustrating a remote plasma generation apparatus according to a fourth exemplary embodiment of the present invention.

Referring to FIG. 8, a remote plasma generation apparatus 400 of the fourth exemplary embodiment has the same configuration as that of one of the foregoing first exemplary embodiment to third exemplary embodiment, except that a ground electrode 30 is formed with a first ground electrode 31 that supports a processing object 40 and a second ground electrode 32 that is fixed to a dielectric support body 10. FIG. 8 illustrates a basic configuration of the first exemplary embodiment, and in the fourth exemplary embodiment, constituent elements identical to or corresponding to those of the first exemplary embodiment are denoted by the same reference numerals.

The second ground electrode 32 contacts an outer wall of a main body 15 of the dielectric support body 10, and may be disposed to enclose the dielectric support body 10 in a width direction. The second ground electrode 32 is positioned between a driving electrode 20 and a nozzle portion 16, and maintains a constant distance from each of the driving electrode 20 and the nozzle portion 16.

In a fourth exemplary embodiment having the second ground electrode 32, at the inside of the dielectric support body 10, plasma discharge occurs by a potential difference between the driving electrode 20 and the second ground electrode 32. Therefore, in a structure of the fourth exemplary embodiment, a plasma generation source is positioned far from the processing object 40 and remote plasma strongly occurs over a wider area using an enlarged ground potential, compared with the foregoing first to third exemplary embodiments. Further, an influence of neutral particles/radicals on the processing object 40 may be reinforced.

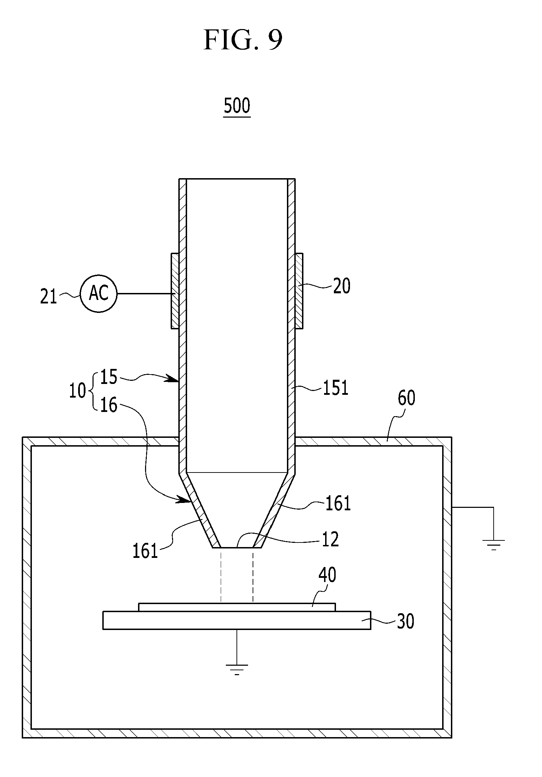

FIG. 9 is a cross-sectional view illustrating a remote plasma generation apparatus according to a fifth exemplary embodiment of the present invention.

Referring to FIG. 9, a remote plasma generation apparatus 500 of the fifth exemplary embodiment has a configuration of one of the foregoing first exemplary embodiment to fourth exemplary embodiment, except that a chamber 60 is installed to enclose a nozzle portion 16. FIG. 9 illustrates a basic configuration of the first exemplary embodiment, and in the fifth exemplary embodiment, constituent elements identical to or corresponding to those of the first exemplary embodiment are denoted by the same reference numerals.

The chamber 60 is fixed to a lower end portion of a main body 15 of a dielectric support body 10 so as to enclose the nozzle portion 16, and a processing object 40 and a ground electrode 30 are positioned within the chamber 60. The inside of the chamber 60 is connected to a vacuum pump (not shown) to have a pressure condition different from that of the air. The chamber 60 is connected to a ground potential like the ground electrode 30 to strongly generate remote plasma over a wider area, and reinforces an influence of neutral particles/radicals for the processing object 40.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

### <Description of Symbols>

100, 200, 300, 400: remote plasma generation apparatus
10, 10a: dielectric support body 11: discharge gas injection opening
12: plasma outlet 15, 153: main body
151: long side portion 152: short side portion
16, 163: nozzle portion 161: inclined surface, first inclined surface
162: second inclined surface 20: driving electrode
30: ground electrode 50: transfer roller
60: chamber

## Claims

1. A remote plasma generation apparatus, comprising:
a dielectric support body that has a main body that is connected to a discharge gas injection opening and a nozzle portion that is connected to a plasma outlet;
a driving electrode that is fixed to the main body and that receives an AC voltage from a power supply unit to generate plasma at an internal space of the main body; and
a ground electrode that supports a processing object at the outside of the nozzle portion,
wherein the nozzle portion comprises an inclined surface that is integrally connected to the main body, and by forming a width of the plasma outlet to be smaller than a width of the main body, remote plasma is concentrated to the processing object.

2. The remote plasma generation apparatus of claim 1, wherein the main body comprises a pair of long side portions that are opposite to each other in a first direction and a pair of short side portions that are opposite to each other in a second direction.

3. The remote plasma generation apparatus of claim 2, wherein the inclined surface comprises a pair of inclined surfaces that are opposite to each other in one direction of the first direction and the second direction.

4. The remote plasma generation apparatus of claim 2, wherein the inclined surface comprises a pair of first inclined surfaces that are opposite to each other in the first direction and a pair of second inclined surfaces that are opposite to each other in the second direction.

5. The remote plasma generation apparatus of claim 1, wherein the main body is formed in a cylindrical shape, and
the nozzle portion is formed in a funnel shape and thus the plasma outlet has a smaller diameter than that of the main body.

6. The remote plasma generation apparatus of any one of claims 1 to 5, further comprising a plurality of transfer rollers that are positioned at both sides of the ground electrode,
wherein the plurality of transfer rollers move the processing object in one direction in a remote plasma processing process.

7. The remote plasma generation apparatus of any one of claims 1 to 5, wherein the ground electrode comprises a first ground electrode that supports the processing object and a second ground electrode that is fixed to the dielectric support body.

8. The remote plasma generation apparatus of claim 7, wherein the second ground electrode contacts an outer wall of the main body and is positioned between the driving electrode and the nozzle portion.

9. The remote plasma generation apparatus of any one of claims 1 to 5, further comprising a chamber that encloses the nozzle portion and that is fixed to the main body,
wherein the chamber is connected to a ground potential.
